# EUROPEAN PATENT APPLICATION

(11) **EP 2 211 223 A1**
(43) Date of publication of application: **28.07.2010**
(21) Application number: 09000973.9
(22) Date of filing: 23.01.2009
(51) Int. Cl.: G02B 26/08, B81C 1/00, G03F 7/20

(54) **Method for generating a deflectable mirror structure and a micromirror device**

(71) Applicant: Fraunhofer-Gesellschaft zur Förderung der angewandten Forschung e.V., 80686 München (DE)
(72) Inventor: Bring, Martin, Dr., 01465 Langebrueck (DE); Zimmer, Fabian, 01199 Dresden (DE); List, Matthias, Dr., 01129 Dresden (DE); Duerr, Peter, Dr., 01199 Dresden (DE)
(74) Representative: Stöckeler, Ferdinand

(57) **Abstract**

Summary

A method for generating a deflectable mirror structure comprises forming a hinge structure (15) in a first monocrystalline silicon device layer (14) above a substrate (10) comprising an address electrode and forming, in a second device layer (44) above the first monocrystalline silicon device layer (14), a mirror structure (48) supported by the hinge structure. A micromirror device comprises a deflectable mirror structure generated accordingly.

## Description

The present invention relates to a method for generating a deflectable mirror structure and, in particular, to a method for generating a deflectable mirror structure comprising a hinge structure and a mirror structure in different device layers.

The use of micromirror arrays as spatial light modulators, so-called SLMS, in adaptive optics and photolithographic applications, set extreme requirements on the performance of the micromirrors. Despite significant progress, there is still the need for improvement of the micromirror performance.

Early micromirror arrays consisted of one metal layer, typically an aluminum alloy in which both the hinge and mirror were structured. Such a spatial light modulator is described in US 5,956,619. This approach suffers from a trade-off between the mechanical and optical properties of the layer.

A separation of the hinge layer from the mirror layer facilitates individual optimization of the mechanical and optical properties. US 5,600,383 describes a multi-level micromirror in which a hinge layer and a micromirror layer are formed of an aluminum alloy. In the approach described in US 5,600,383, the material for the hinge layer has to be chosen from materials that can be deposited using a CMOS compatible deposition process, which limits the mechanical performance.

To further improve the performance, monocrystalline silicon has been proposed as an ideal material for the micromirror hinges. However, it is not at all obvious and straightforward how to realize such micromirrors. Recently, methods that allow the use of monocrystalline silicon as hinge and mirror material have been disclosed in US 7,396,740; US 7,372,617; F. Niklaus et al., "Arrays of Monocrystalline Silicon Micromirrors Fabricated Using CMOS Compatible Transfer Bonding", Journal of Micro-Electromechanical Systems, Vol. 12, No. 4, August 2003, pp. 465-469; and Thor Bakke et al., "Large Scale, Drift Free Monocrystalline Silicon Micromirror Arrays made by Wafer Bonding", Proc. Of SPIE, Vol. 6114611402-1. The drawback with these approaches is that, once more, the hinge and mirror are defined in the same layer. For photolithographic applications, a highly planar mirror with high reflectance is very important. Deep ultraviolet light with a wavelength of 248nm is very common in such applications and at this wavelength, the reflectance is only around 65% for monocrystalline silicon. By depositing an additional layer, such as aluminum on top of the monocrystalline silicon, it is possible to greatly increase the reflectance, e.g. >90%. However, by doing this, unwanted artifacts are introduced.

Micromirrors with the hinge and mirror formed in the same structural layer suffer from a bimorph effect whenever an additional reflectance-increasing layer is used. Another drawback of this approach is that any reflectance increasing layers on top of the hinge will deteriorate the mechanical stability, e.g. creep and fatigue of the otherwise extremely stable monocrystalline silicon. By separating the hinge and mirror layer, it is therefore possible to realize a micromirror structure that is less sensitive to temperature fluctuations.

The formation of multi-level micromirrors with monocrystalline silicon hinges and a reflecting element defined in separate layers has been described in US 2005/0162727 A1. However, in this document, the formation of the monocrystalline hinge layer is done before the fabrication of the addressing electrodes. Moreover, this document does not include any concrete example of how to fabricate any addressing circuitry.

It is the object of the present invention to provide for a method for generating a deflectable mirror structure in an easy manner and to provide for a micromirror device comprising a deflectable mirror structure generated accordingly.

This object is achieved by a method according to claim 1 and a micromirror device according to claim 15.

Embodiments of the invention provide for a method for generating a deflectable mirror structure, comprising:
forming a hinge structure in a first monocrystalline silicon device layer above a substrate comprising an address electrode; and
forming, in a second device layer above the first monocrystalline silicon device layer, a mirror structure supported by the hinge structure.

Embodiments of the invention provide for a micromirror device comprising a deflectable mirror structure generated by such a method. Embodiments of the present invention provide for a micromirror device in which a hinge structure and a micromirror structure are formed in different device layers on top of a substrate, which is formed by standard CMOS technology, i.e. in which the addressing electrodes and optionally mirror driving electrodes are formed in an upper metallization layer of the CMOS substrate. Driving circuitry for applying an appropriate voltage difference between the mirror structure and the addressing electrode may also be provided in the CMOS substrate. It is clear that the driving circuitry may comprise addressing circuitry configured to apply appropriate voltages to desired ones of addressing electrodes and mirror driving electrodes of an array of micromirror devices.

Embodiments of the present invention allow for the realization of multi-level micromirror arrays with monocrystalline silicon hinges placed in a layer different from the mirror layer on top of existing address circuitry. In embodiments of the invention, the process of forming the hinge structure and the micromirror structure can be utilized in combination with standard CMOS technology to realize spatial light modulators (SLMs) with micromirrors that have monocrystalline silicon hinges in a layer different from the mirror layer. The mirror layer may be formed of an aluminum alloy. Therefore, mirrors according to embodiments of the invention may have improved mirror stability with minimum short and long-term drift and increased optical performance compared to currently employ micromirror-based SLMs.

According to the invention, a hinge structure and a mirror structure are formed in different device layers starting from a substrate, which already comprises one or more address electrodes and which may also already comprise one or more mirror driving electrodes and a driving circuitry, which may include an addressing circuitry.

The term "address electrode" is used herein to designate a conductive portion on the substrate, which is arranged opposite to a portion of the micromirror structure in order to permit deflection of the micromirror structure by applying a voltage difference between the micromirror structure and the address electrode. The term "mirror driving electrode" is used herein to designate a conductive portion on the substrate, which is electrically connected to the mirror structure.

According to the invention, the address electrodes already exist in or on the substrate when forming the hinge structure and the mirror structure, so that forming the address electrode and the address circuitry must no longer be taken into consideration when forming the hinge structure and the mirror structure. In embodiments of the invention, the mirror driving electrodes and the driving circuitry also already exist when forming the hinge structure and the mirror structure.

Embodiments of the present invention are described, referring to the drawings, in which identical elements or elements having the same functionality are provided with the same reference numbers.
- Fig. 1: shows schematic cross-sectional views illustrating different steps of an embodiment of the inventive method;
- Fig. 2: shows a schematic plan view of a micromirror device;
- Figs. 3a to 3c: show schematic cross-sectional views along lines A-A and B-B of Fig. 2;
- Fig. 4: shows a schematic view of mirror driving electrodes and hinge posts;
- Fig. 5: shows a schematic plan view of a hinge structure;
- Figs. 6 to 10: show schematic cross-sectional views illustrating different steps of alternative embodiments of the inventive method.

Embodiments of the invention may be used to generate spatial light modulators for photolithographic applications based on Fourier optics. Such an SLM requires a deflection equivalent to λ2 across the mirror plate or only 124nm for DUV (dark ultraviolet) lithography based on a wavelength of 248nm. The small deflection angle requires an exceptional mirror planarity in the order of nanometers as well as high mirror stability with minimum short and long-term drift. A high reflectance and a high optical fill factor are also of importance. The ideal mechanical properties of monocrystalline silicon make this material well suited for use in high precision optical MEMS devices, like micromirror-based SLMs for photolithographic applications.

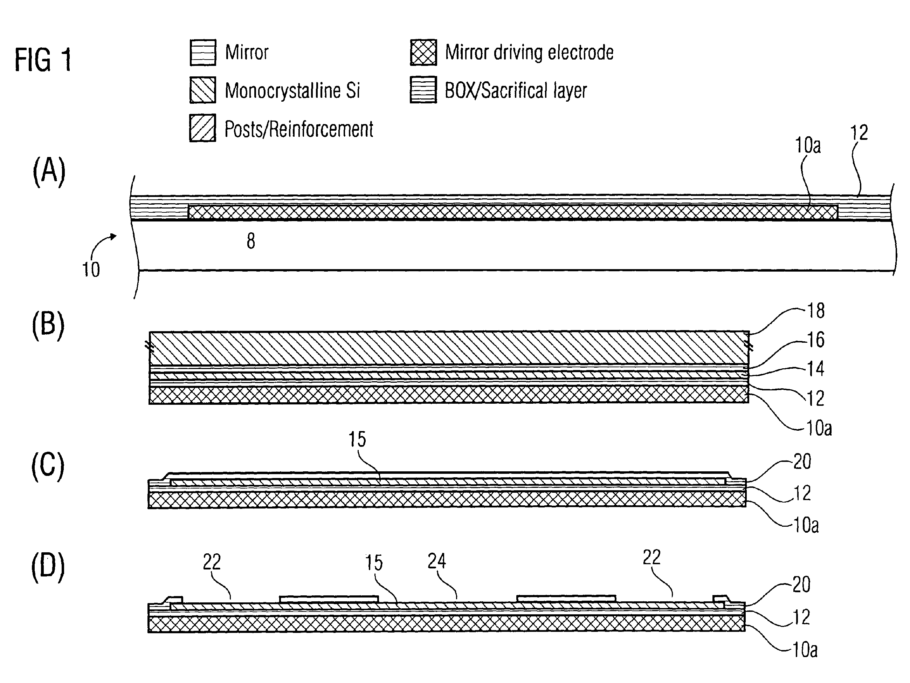

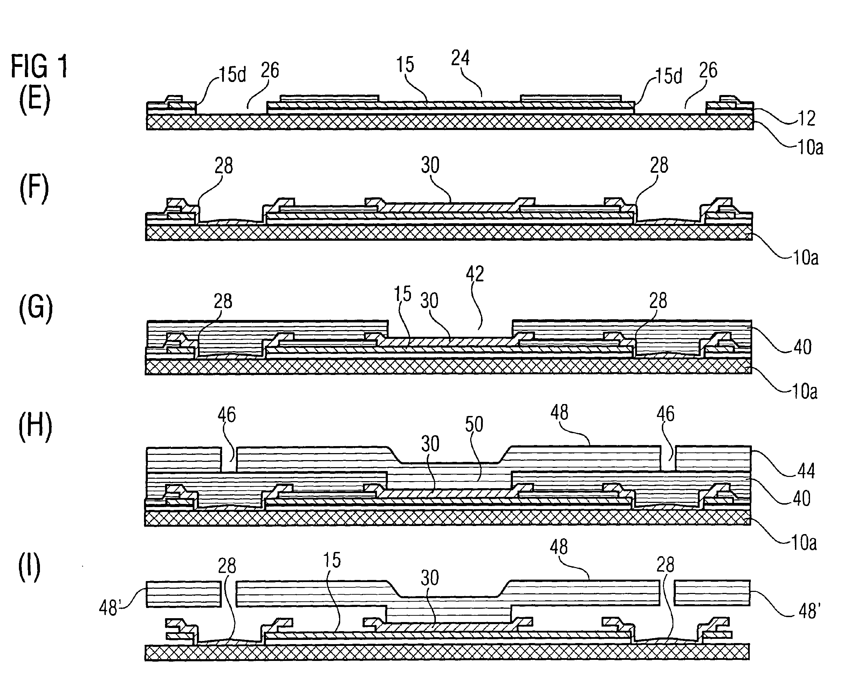

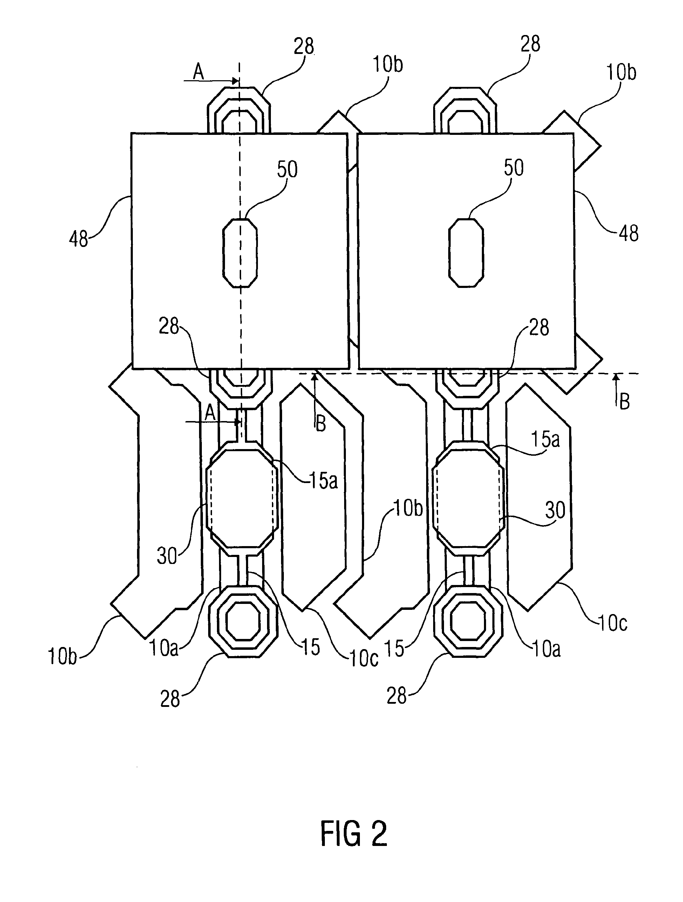

An embodiment of a method for generating a deflectable mirror structure in the form of a multi-level spatial light modulator with a monocrystalline silicon hinge, which may be used for DUV photolithographic applications, for example, is explained using the process flow illustrated in Fig. 1. A corresponding micromirror device is described referring to Figs. 2 to 5.

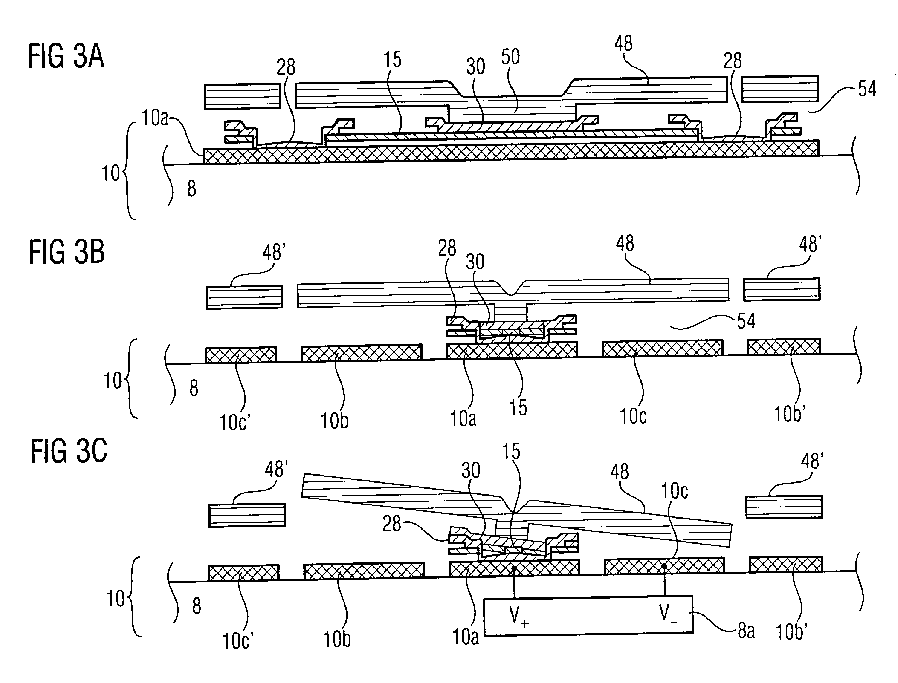

Starting point of the method shown in Fig. 1A is a substrate 10 comprising a carrier substrate 8, a mirror driving electrode 10a and address electrodes 10b, 10c. The address electrodes 10b, 10c are shown in Figs. 3a and 3b.

The carrier substrate 8 may comprise a CMOS substrate comprising driving circuitry for applying appropriate voltages to the mirror diving electrodes and the address electrodes to deflect an associated mirror structure. The driving circuitry may comprise addressing circuitry to address selected ones of an array of micromirror structures. The mirror driving electrode(s) and the address electrode(s) may be formed in the uppermost metallization layer of the CMOS substrate.

For sake of simplification of the drawings, Figs. 1B to 1I and Figs. 6 to 10 show the mirror driving electrode 10a as part of the substrate 10. It is to be understood that same is respectively formed on a substrate also comprising address electrodes. In all embodiments of the invention, the substrate including the address electrodes and, optionally, the mirror driving electrodes and the address circuitry, forms the starting point for generating the deflectable mirror structure.

On top of the substrate 10 comprising the mirror driving electrode 10a and the address electrodes, a planarized spacer 12 is formed. The spacer represents a sacrificial layer. The spacer 12 is formed on top of the address electrodes and the mirror driving electrodes and may be planarized by CMP (chemical mechanical polishing) to a thickness of 250nm over the address electrodes. The spacer 12 may be formed of inorganic material, such as undoped silicate glass (USG) applied by plasma-enhanced chemical vapor deposition (PE-CVD). Alternatively, the planarized spacer 12 may be formed spin-coated and/or chemically mechanically planarized organic material, such as photo resists, bensocyclobutene (BCB) or polyimide (PI).

As shown in Fig. 1B, an SOI wafer comprising a device layer 14 of monocrystalline silicon, an insulation layer 16 (BOX layer = buried oxide layer) and a handle substrate 18 is bonded to the spacer 12. The device layer 14 may have a thickness of 200nm. The device layer may be bonded to the spacer layer 12 by using plasma-activated low temperature direct wafer bonding.

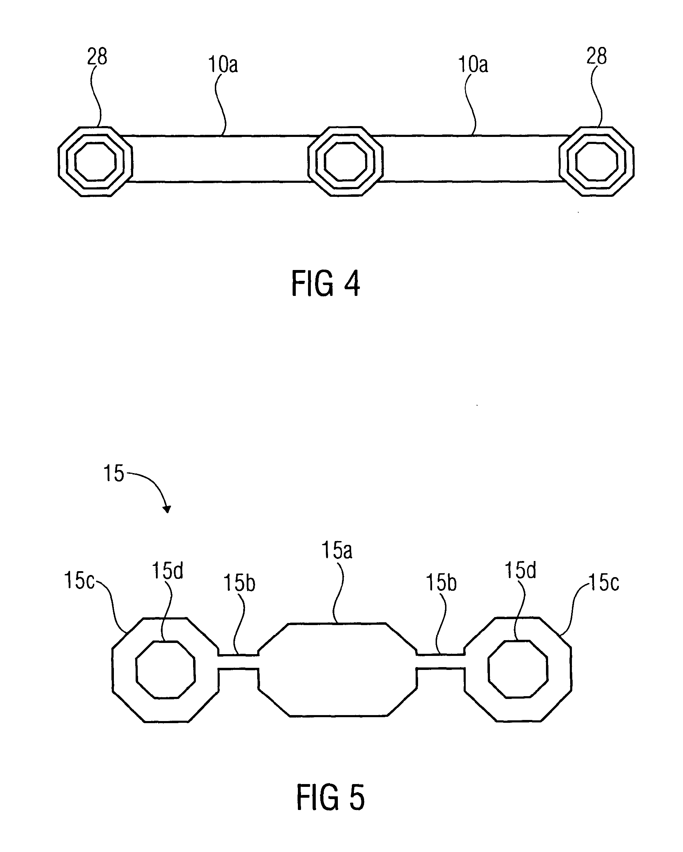

Upon wafer bonding, the handle wafer 18 is removed from the bonded SOI wafer, such as by grinding and spin etching. Then, the isolation layer 16 is removed and the device layer 14 is patterned to form a hinge structure 15 (Fig. 1C). A possible outer shape of the hinge structure after the patterning step is shown in Fig. 5. The hinge structure 15 comprises a mirror contact land portion 15a (on which a mirror contact is formed later on), hinge arm portions 15b and mounting portions 15c at which the hinge structure is mounted to hinge posts later on. Holes 15d in the hinge structure are formed in a later step (Fig. 1E).

A protective sacrificial layer 20 is formed on the top surface of the structure as shown in Fig. 1C. The protective layer 20 may be formed as a 150nm PE-CVD USG layer.

Thereupon, layer 20 is patterned with recesses 22 at positions where hinge posts are formed later on and with a recess 24 at a position 24 where a mirror contact is formed later on (Fig. 1D). Thereupon, the monocrystalline silicon layer 14, i.e. the hinge structure 15, and the underlying spacer 12, which represents a sacrificial layer, are patterned with holes 26 in which hinge posts are formed later on(Fig. 1E). In this step, the mounting holes 15d in the hinge structure are formed.

Thereupon, hinge posts 28 are formed within the holes 26 and overlapping the device layer 14 and the sacrificial layer 20. The lateral dimensions of the recesses 22 in the layer 20 exceed lateral dimensions of the holes 26 to obtain the overlap. Concurrent with the hinge posts 28 in holes 26, a mirror contact 30 is formed in recess 24. The mirror contact 30 is formed on the land portion 15c of the hinge structure 15. Mirror contact 30 may act as a reinforcement structure for the land portion 15c.

Hinge posts 28 and mirror contact 30 may be formed by sputtering a metallic layer, such as an AL-alloy layer and by patterning the layer to obtain the hinge posts 28 and the reinforcement structure 30. The metallic layer may be sputtered with a thickness of about 250nm. The resulting structure is shown in Fig. 1F.

Thereupon, a further sacrificial layer 40 is applied and planarized. For example, the sacrificial layer 40 may be a PE-CVD USG layer deposited to a thickness of about 1200nm. Thereupon, layer 40 may be planarized by chemically mechanically planarization (CMP), for example, to a thickness of about 600nm over the monocrystalline silicon layer forming the hinge structure. Thereupon, the sacrificial layer 40 is patterned with a hole 42 extending to the mirror contact 30. Later on, a mirror post will be formed within the hole 42. The structure after patterning the hole 42 is shown in Fig. 1G.

Then, a mirror layer 44 representing a second device layer is deposited. The mirror layer 44 is patterned to form a mirror structure 48. In this regard, recesses 46 may separate mirror structure 48 from neighboring mirror structures 48'. As it is shown in Fig. 1H, a part of the mirror layer 44 fills hole 42 and forms a mirror post 50 on the mirror contact 30.

As the mirror layer 44, an aluminum alloy layer may be sputtered to a thickness of about 750nm, for example.

The cross-sectional views of Fig. 1 show a single mirror structure only. However, it is clear for a person skilled in the art that a plurality of corresponding structures are formed on a wafer level, wherein a step of dicing the wafer into chips may follow the steps for obtaining the structure shown in Fig. 1H.

Thereupon, the sacrificial layers, such as layers 12, 20 and 40 are removed to release the mirror structure 48. The sacrificial layers may be removed by HF-GPE (hydrogen fluoride gas phase etching). Thus, a micromirror device comprising a deflectable mirror structure as shown in Figs. 1I is obtained. In embodiments of the invention, a micromirror device comprising plurality of mirror structures, such as an array of mirror structures, will be formed.

A top view of an array comprising four pixels, each pixel comprising a mirror structures is shown in Fig. 2. In Fig. 2, the mirror structures 48 of the two lower pixels are omitted to show otherwise hidden structures.

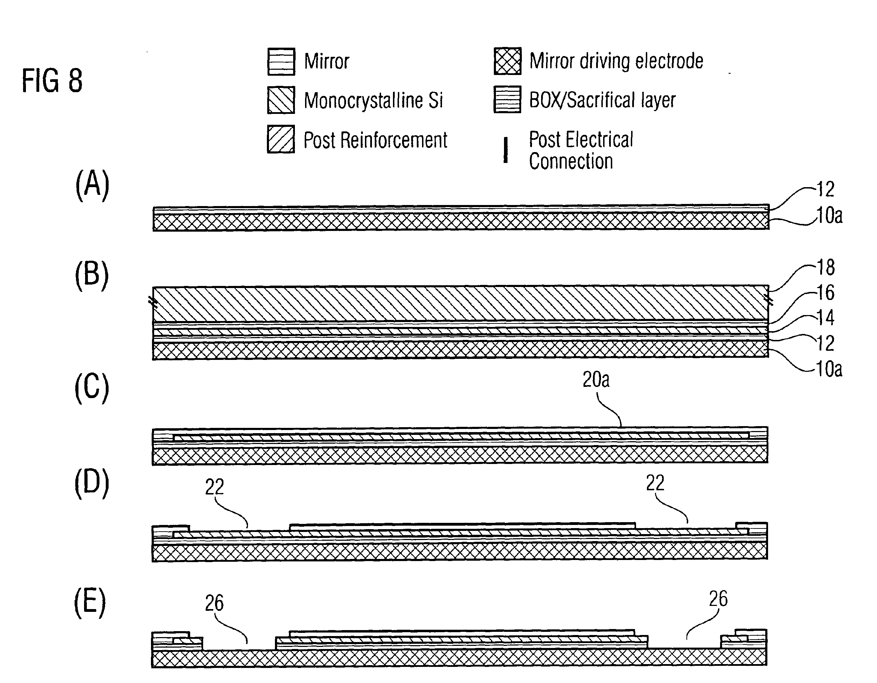

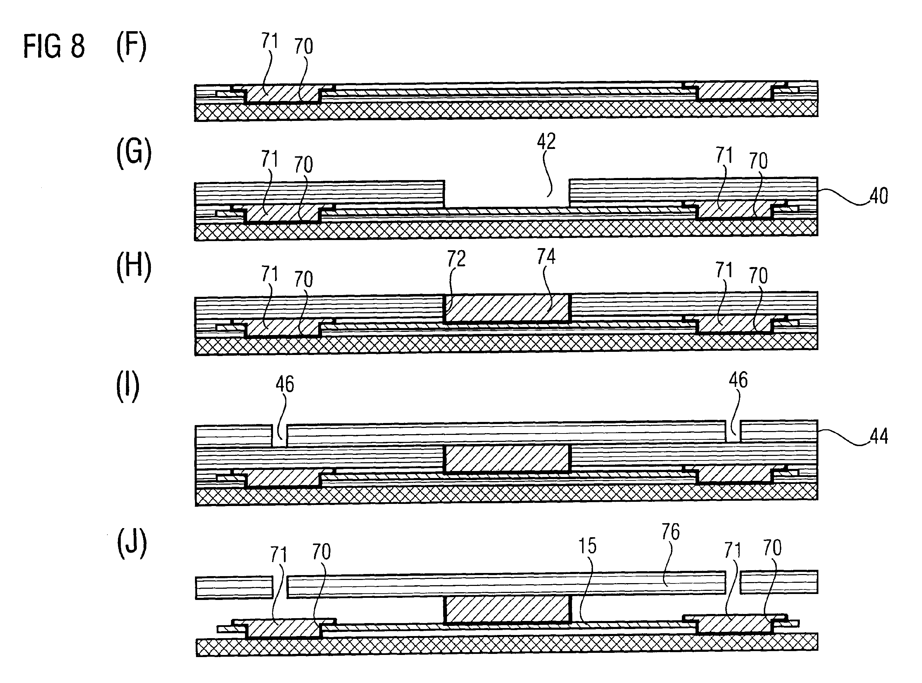

Fig. 2 shows a plurality of six hinge posts 28 which are arranged to be electrically connected to the mirror driving electrodes 10a. A schematic view of an arrangement of three of the hinge posts 28 and mirror driving electrodes 10a is shown in Fig. 4. Fig. 8 further shows the hinge structures 15 of the lower pixels and the mirror contacts 30 arranged on the mirror contact land portions 15a. In addition, Fig. 2 shows the address electrodes 10b and 10c associated with the lower pixels. Portions of address electrodes 10b of the upper pixels, which are not hidden by the mirror structures 48 are also shown in Fig. 2.

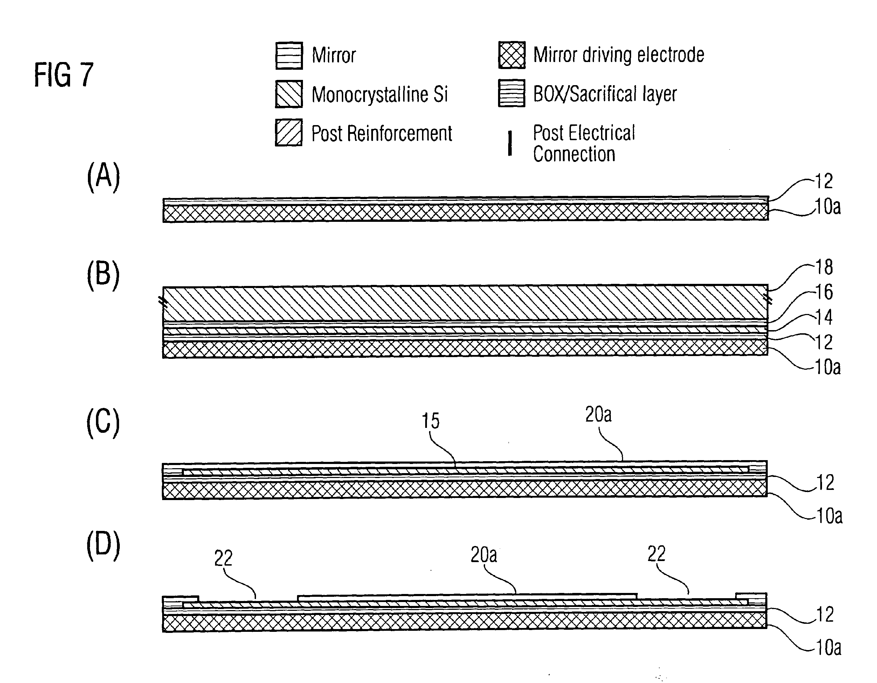

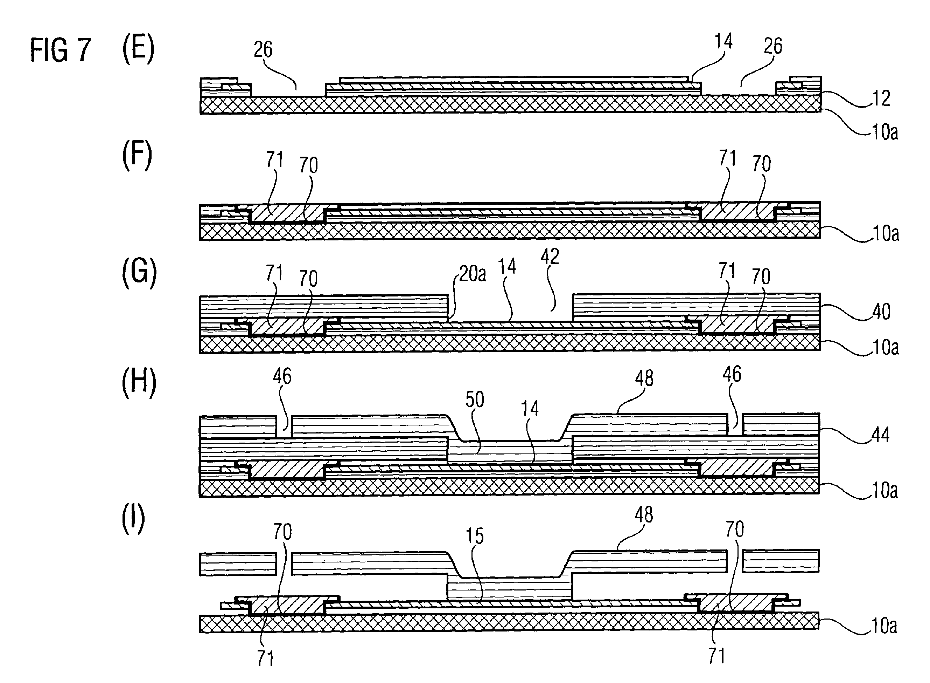

Fig. 3a shows a cross-sectional view along line A-A of Fig. 2, while Figs. 3b and 3c show a cross-sectional view along line B-B of Fig. 2. Fig. 3b shows the mirror structure in a non-deflected position, and Fig. 3c shows the mirror structure 48 in a deflected position. Address electrodes 10b' and 10c' associated with neighboring mirror structures 48' are also indicated in Figs. 3a and 3b. A gap 54 between the mirror structure 48 and the address electrodes is schematically indicated in Fig. 7.

Hinge posts 28 may be electrically connected to the mirror driving electrode 10a and may be electrically connected to the mirror structure 48 via the hinge structure 15. Thus, an electrical potential can be applied to the mirror structure 48 via the mirror driving electrode 10a.

Thus, a voltage difference can be applied between a selected one of the address electrodes such as electrode 10c in Fig. 3c, and the associated mirror structure 48 in order to effect deflection of the mirror structure 48 by electrostatic attraction as shown in Fig. 3c. A driving circuitry 8a which my be formed in CMOS substrate 8 is schematically shown in Fig. 3c.

A specific embodiment of a method for generating a micromirror device has been described referring to Fig. 1 illustrating a process flow for a multi-level micromirror with a monocrystalline silicon hinge in which electrically conductive posts and a reinforcement at a mirror contact are provided.

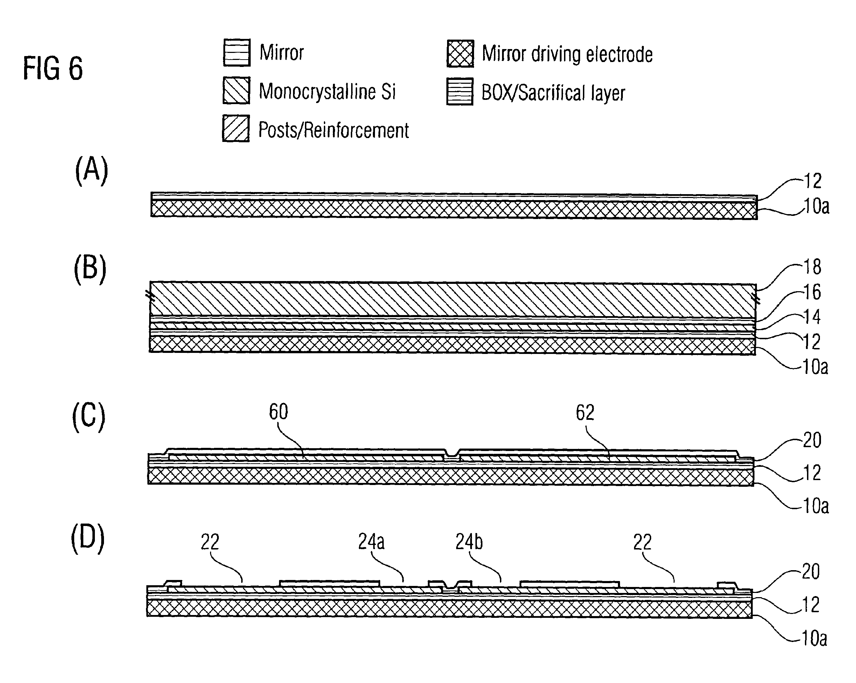

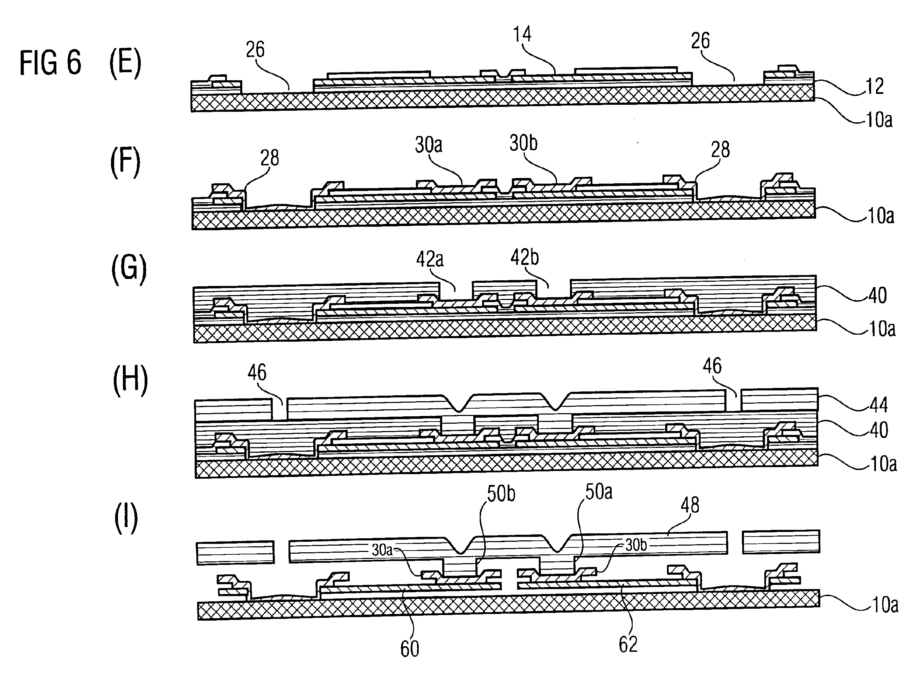

In the following, further embodiments of the invention will be described referring to Figs. 6 to 10.

As already mentioned above, in Figs. 6, 7, 8, 9 and 10, the mirror driving electrode 10a is shown only in place of the substrate 10.

In the embodiment shown in Fig. 6, when compared to the embodiment shown in Fig. 1, two separate hinge structures 60, 62 and divided mirror contacts 30a, 30b are formed. The steps resulting in the structure shown in Fig. 6B are identical to those explained above with respect to Fig. 1. According to Fig. 6C, layer 14 is patterned to obtain two separate hinge structures 60 and 62 prior to applying the protective sacrificial layer 20 (Fig. 6C). Thereupon, layer 20 is patterned to include holes 22 at the positions of hinge posts and at holes 24a, 24b at the positions of mirror contacts (Fig. 6D). Thereupon, hinge post holes 26 are formed in the monocrystalline silicon layer 14 and the spacer 12 (Fig. 6E). Thereupon, hinge posts 28 and mirror contacts 30a and 30b are obtained in the same manner as explained above with respect to Fig. 1F. Again, the mirror contacts 30a and 30b may form reinforcement structures. In the following steps, sacrificial layer 40 is applied and two mirror post recesses 42a and 42b are formed within the sacrificial layer 40. Then, a mirror layer 44 is applied and patterned. By these steps, a mirror structure 48 comprising two mirror posts 50a and 50b attached to the separate hinge structures 60 and 62 via mirror contacts 30a and 30b are obtained.

Referring to Fig. 7, an embodiment is described comprising electrically conductive lining in hinge posts and planarized hinge post reinforcement. The steps resulting in the structure shown in Fig. 7B are identical to those explained above with respect to Figs. 1A and 1B.

After having patterned device layer 14 as shown in Fig. 1C to form a hinge structure 15, sacrificial layer 20a is applied and planarized. Holes 22 at positions of hinge posts are patterned in sacrificial layer 20a (Fig. 7D). Hinge post holes 26 are patterned into the device layer 14 and the spacer 12. As shown in Fig. 7E, the lateral extension of the hinge post holes 26 is less than the lateral extension of the holes patterned in the sacrificial layer 20a.

An electrically conductive lining 70 is deposited into the hinge post holes 26 and, then, a reinforcement layer 71 is deposited and planarized to fill the hinge post holes 26. The conductive lining 70 may be formed of Ti, A1-alloy or TiN, for example. The to fill the hinge post holes 26 and the holes within the sacrificial layer 20a (see Fig. 7F). The reinforcement layer does not need to be conductive and may be formed of amorphous silicon which is chemically mechanically planarized.

For this approach, it is important that the reinforcement layer is not removed in the following release etch, in which the sacrificial layers, such as USG spacers, are removed. The sacrificial layer 20a may be used as a stop layer in a CMP step of the reinforcement layer 71. In order to obtain good adhesion between lining and hinge, an appropriate cleaning step before deposition of the lining may be used, e.g. an in-situ sputter cleaning.

The lining 70 and the reinforcement layer 71 form hinge posts and sides of the lining 70 overlap the device layer 14 forming the hinge structure so that the hinge structure is attached to the hinge posts 70.

Thereupon, as in the other embodiments, a further sacrificial layer 40 and mirror layer 44 are applied and patterned. As shown in Fig. 7G, along with sacrificial layer 40, sacrificial layer 20a is patterned to obtain a mirror post hole 42 extending down to the hinge structure 15 formed in the device layer 14. Thus, upon depositing the mirror layer 44, same is directly supported on the device layer 14 by mirror post 50. The resulting structure upon removal of the sacrificial layers in which hinge structure 15 is supported by hinge posts 70 and mirror structure 48 is supported directly on hinge structure 15 is shown in Fig. 7I.

Fig. 8 shows an embodiment comparable to the embodiment shown in Fig. 7, but comprising a planarized mirror post reinforcement 74. The steps for obtaining the structure shown in Fig. 8G are identical to the steps explained above with respect to Fig. 7A to 7G. According to Fig. 8H, a lining 72 is deposited into mirror post hole 42. Then, a reinforcement layer 74 is formed on lining 72 and planarized. The lining 72 and the reinforcement layer 74 may be formed of the same materials as linings 70 and reinforcement layers 71.

Upon forming lining 74 (Fig. 8H), mirror layer 44 is applied and patterned (Fig. 8I) such that after removal of the sacrificial layers, movable mirror structure 76 attached to hinge structure 15 via lining 72 and reinforcement layer 74 (Fig. 8J) is obtained.

In the embodiments shown in Figs. 1, 6, 7 and 8, hinge post holes and hinge posts are formed after applying the first device layer 14 to the sacrificial layer 12.

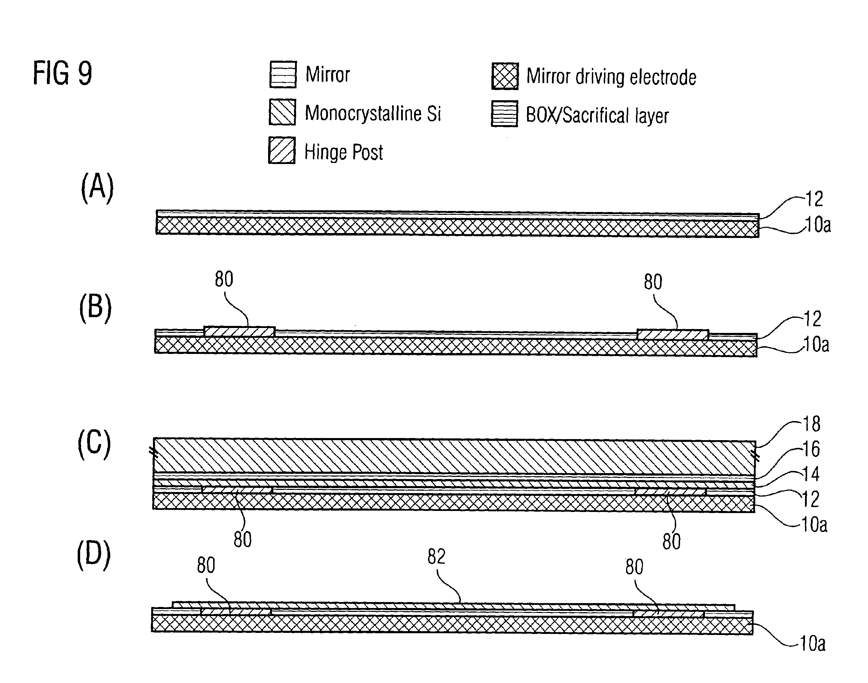

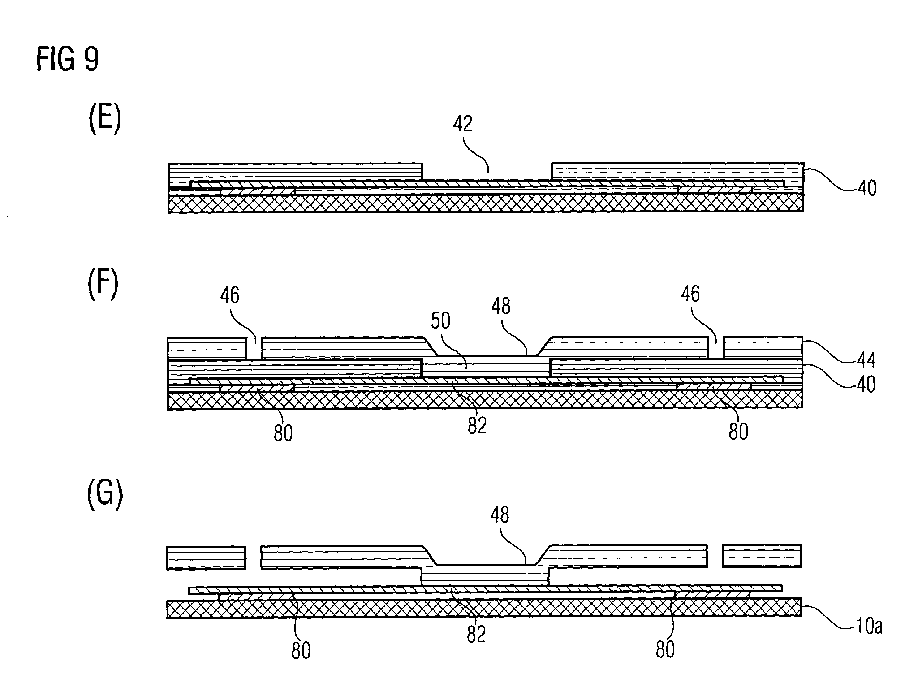

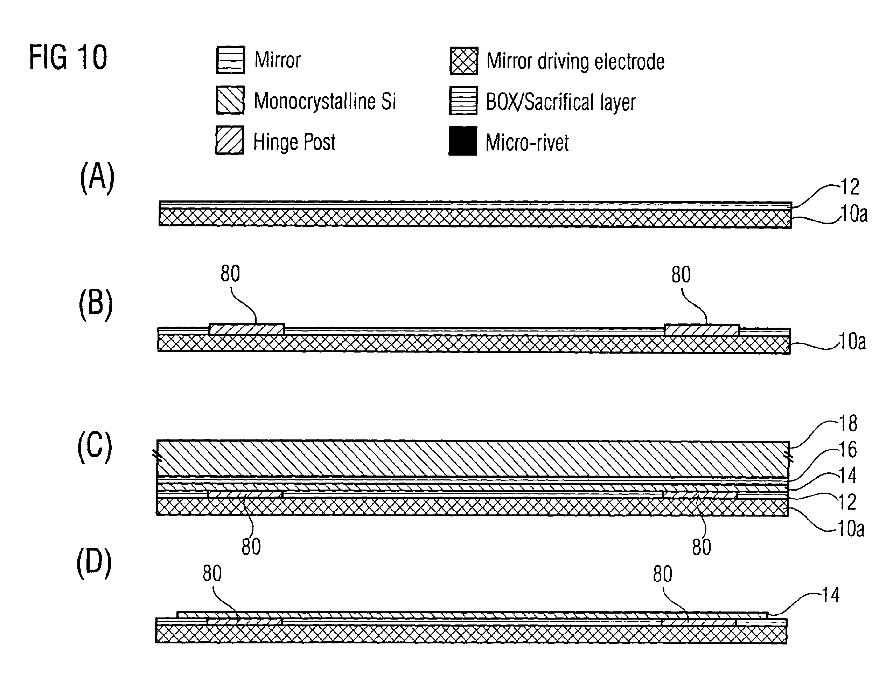

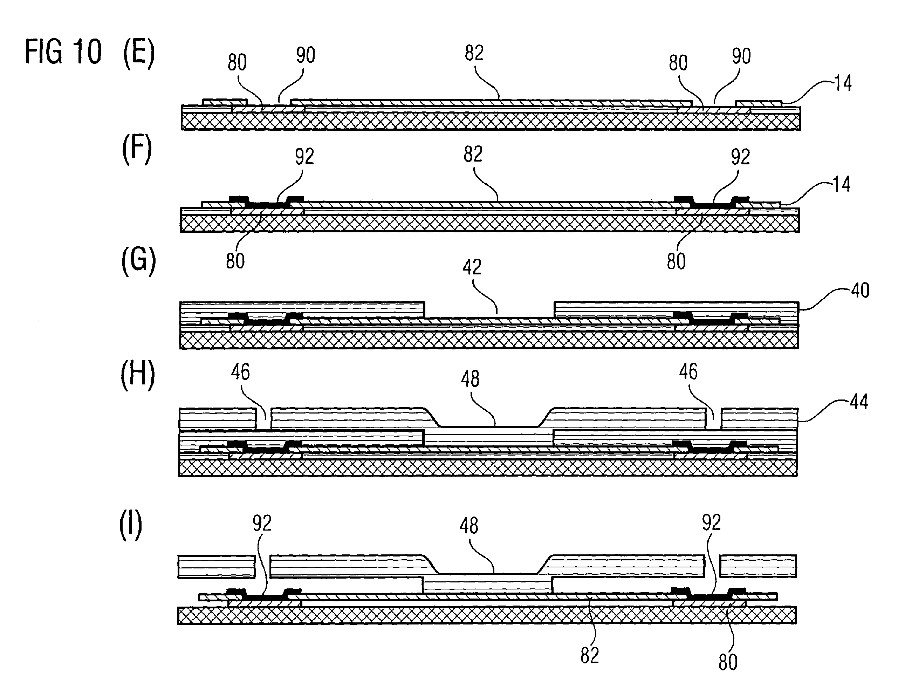

Figs. 9 and 10 show embodiments in which hinge posts are formed prior to applying the first device layer 14.

According to the embodiment shown in Fig. 9, starting from the structure comprising substrate 10 and spacer 12, hinge post holes are formed in spacer 12. The hinge post holes are filled with hinge posts 80 formed of a conductive material, gold, for example (see Fig. 9B). The hinge posts 80 are planarized and the SOI substrate comprising the first device layer 14, the isolator layer 16 and the handle layer 18 is bonded to the upper surface of the spacer 12 and the hinge posts 80. In this manner, device layer 14 may be attached to the hinge posts 80 by eutectic bonding, e.g. gold silicon eutectic bonding. In order to maintain a good bond in this approach, it might be appropriate not to exceed the eutectic temperature, e.g. 363°C for gold silicon in the continued processing.

Upon bonding the SOI wafer, the handle substrate 18 and the isolator layer 16 are removed and the device layer 14 is patterned to obtain a hinge structure 82. Thereupon, sacrificial layer 40 is applied and patterned to include mirror post hole 42 (see Fig. 9E). Then, mirror layer 44 is applied and structured as shown in Fig. 9F. Since mirror post hole 42 reaches the upper surface of hinge structure 82, mirror post 50 formed in mirror post hole 42 is directly attached to the upper surface of hinge structure 82. Upon removal of the sacrificial layers, a micromirror device having the structure shown in Fig. 9G is obtained in which hinge structure 82 is attached to substrate 10 via hinge posts 80 and in which mirror structure 48 is supported directly on the upper surface of hinge structure 82.

To further secure the hinge layer to the hinge posts 80, it is possible to use micro-riveting as shown in Fig. 10. When using micro-rivets, additional holes at the ring posts are patterned in the hinge layer and the micro-rivets are formed by depositing and patterning a structural material, such as TIN or an AL-alloy.

Figs. 10A to 10D are identical to Figs. 9A to 9D. As shown in Fig. 10E, holes 90 are patterned within the hinge structure 82 to expose the upper surface of hinge posts 80. Thereupon, a structural material 92 is deposited and patterned such that portions of hinge structure 82 are arranged between micro-rivets 92 and hinge posts 80. Thus, hinge structure 82 is more securely attached to hinge posts 80. The remaining steps shown in Figs. 10G to 10I correspond to the steps shown in Figs. 9E to 9G and result in a micromirror device structure as shown in Fig. 10I, in which hinge structure 82 is attached to hinge posts 80 by means of micro-rivets 92.

According to embodiments of the invention, the device layer of an SOI wafer is bonded to a planarized address circuitry, e.g. by low temperature <400°C plasma-assisted bonding (see Figs. 1B, 6B, 7B and 8B). By using a USG spacer, which was chemically mechanically planarized, plasma-activated bonding and a 400°C anneal of the bonded wafers, it is possible to reach high surface energies, e.g. 2.0 J/m², which may be important during the continued processing. Appropriate cleaning and pretreatment may be performed before bonding to eliminate void formation in the post bond anneal step. By using such an approach, it is possible to avoid using spin-on-glass, which otherwise leaves residues on the backside of the mirror after release. Another advantage of this approach is that by avoiding using any organic layers, it is possible to use elevated temperatures, such as >300°C, in the following processing, which allows the use of otherwise prohibited processes, such as USG deposition. Nevertheless, it is possible to use intermediate layer bonding, like adhesive bonding, to transfer the device layer, but then the subsequent spacers are to be deposited at low temperatures, such as spin-coating of PI.

As explained above with respect to Figs. 9 and 10, it is also possible to use eutectic bonding, e.g. gold silicon eutectic bonding to transfer the device layer if the hinge posts are formed before the transfer of the hinge layer. To further secure the hinge layer, it is possible to use micro-riveting as illustrated in Fig. 10.

In embodiments of the invention, the handle wafer may be removed, e.g. by grinding and/or spin etching, with the buried oxide (BOX) as a stop layer and the BOX may be removed selectively to the device layer of the SOI wafer, e.g. by HF-GPE. The device layer may be patterned in the shape of hinges and to protect the hinge layer during further processing, an additional sacrificial layer may be deposited, e.g. USG (see Figs. 1C and 2C, for example). The sacrificial layer, e.g. USG, on the hinge layer may be planarized (see Figs. 7C and 8C, for example), e.g. by CMP to avoid residues of the hinge post reinforcement that could otherwise be present in the down areas after CMP.

In embodiments of the invention, holes for the hinge posts (see Fig. 7D and Fig. 8D, for example) and mirror contacts (see Fig. 1D and 6D, for example) may be etched in the sacrificial layer (protective sacrificial layer 20, 20a) down to the hinge layer. Holes for the hinge posts may then be etched down to the address electrodes for the micromirror (see Figs. 1E, 6E, 7E and 8E, for example).

In embodiments of the invention, hinge posts can be created by depositing and patterning an electrically conductive hinge post that also works as the mechanical anchor for the hinge structure, e.g. A1-alloy. This layer can also be used to reinforce the mirror contact, if needed (see Figs. 1F and 2F). An appropriate cleaning step may be used for deposition of the hinge post to ensure good adhesion to the hinge layer. To this end, an in-situ sputter cleaning may be used.

In embodiments of the invention, the mirror posts can optionally be coated with an electrically conductive lining and planarized with a reinforcement layer as described above with respect to Fig. 8. This results in an increased optical fill factor of the mirror (see Fig. 8H). If the reinforcement is conductive, it can also be planarized without the use of a lining, e.g. Al-alloy, Cu. If the hinge layer is used as a choke, it is also possible to skip the electrical contact to the mirror layer.

Alternatively, the mirror posts can be structured before the deposition of the last spacer, e.g. by sputtering and patterning an Al-alloy. The last spacer (sacrificial layer) is then deposited and chemically mechanically polished to reveal the mirror posts before the deposition of the mirror layer.

In embodiments of the invention, the mirror layer is formed of an Al-alloy. The mirror layer is deposited and patterned. Alternatively, the mirror layer may be planarized before/after patterning same to increase the optical fill factor, e.g. by CMP.

Finally, optionally after dicing the wafer into single chips, the movable mirror structures may be released, e.g. by HF-GPE if USG is used as sacrificial layers or by ashing in oxygen plasma if organic spacers (sacrificial layers) are used.

If the above specification does not include any other teaching, in the above methods, the respective steps of patterning may be performed by photolithographic methods as it is obvious for a person skilled in the art.

## Claims

1. Method for generating a deflectable mirror structure, comprising:
forming a hinge structure (15; 60, 62; 82) in a first monocrystalline silicon device layer (14) above a substrate (10) comprising an address electrode; and
forming, in a second device layer (44) above the first monocrystalline silicon device layer (14), a mirror structure (48; 76) supported by the hinge structure (15; 60, 62; 82).

2. Method according to claim 1, comprising forming a first sacrificial layer (12) on the substrate (10) comprising the address electrode and applying the first monocrystalline silicon device layer (14) to the first sacrificial layer (12).

3. Method according to claim 2, wherein applying the first monocrystalline silicon device layer (14) comprises bonding a SOI substrate (14, 16, 18) to the first sacrificial layer (12).

4. Method according to claim 2 or 3, comprising forming a second sacrificial layer (40) above the first monocrystalline silicon device layer (14) and forming the second device layer (44) on the second sacrificial layer (40).

5. Method of one of claims 1 to 4, comprising forming hinge posts (28; 70; 80) supporting the hinge structure (15; 60, 62; 82) on the substrate (10).

6. Method of claim 5, wherein forming hinge posts comprises applying a layer of a conductive material and patterning the layer of conductive material to form hinge posts and a mirror contact from the layer of conductive material.

7. Method of claim 5 or 6, wherein forming hinge posts (28; 70; 80) comprises forming hinge post recesses (26) through the first sacrificial layer (12) prior to or after applying the first monocrystalline silicon device layer (14) to the first sacrificial layer (12) and forming hinge posts (28; 70; 80) within the hinge post recesses (26).

8. Method of claim 7, comprising forming hinge post recesses (26) through the first sacrificial layer (12) and the first monocrystalline silicon device layer (14), further comprising forming a protective sacrificial layer (20; 20a) on the first monocrystalline silicon device layer (14) prior to forming the hinge post recesses (26).

9. Method of claim 8, further comprising a step of patterning the protective sacrificial layer (20, 20a) such that a lateral dimension of recesses (22) in the protective sacrificial layer (20, 20a) exceeds a lateral dimension of the hinge post recesses (26), wherein the hinge posts (28; 70) are formed within the hinge post recesses (26) and the recesses (22) in the protective sacrificial layer (20; 20a) to overlap the hinge structure (15; 60; 62).

10. Method of claim 7, wherein the hinge post recesses and the hinge posts (80) within the hinge post recesses are formed prior to applying the first monocrystalline silicon device layer (14), and wherein the first monocrystalline silicon device layer (14) is applied to extend across the hinge posts (80).

11. Method of claim 10, further comprising forming recesses (90) through the first monocrystalline silicon layer (14) down to the hinge posts (80) and providing micro-rivets (92) within the recesses (90) and overlapping the first monocrystalline silicon device layer (14), such that portions of the first monocrystalline silicon device layer (14) are arranged between the hinge posts (80) and the micro-rivets (92).

12. Method of claim 4, comprising forming at least one mirror post recess (42; 42a; 42b) through the second sacrificial layer (40) and forming at least one mirror post (50; 50a; 50b) within the mirror post recess.

13. Method of one of claims 1 to 12, comprising generating the substrate (10) comprising the address electrode, a mirror driving electrode and a driving circuitry making use of standard CMOS technology.

14. Method of one of claims 1 to 13, wherein forming a hinge structure comprises forming two hinge structures (60; 62) separate from each other, further comprising forming two mirror posts (50a; 50b) attached to the separate hinge structures (60, 62).

15. Micromirror device comprising a deflectable mirror structure generated by a method of one of claims 1 to 14.
